# EUROPÄISCHE PATENTSCHRIFT

(11) **EP 1 593 974 B1**
(45) Veröffentlichungstag und Bekanntmachung des Hinweises auf die Patenterteilung: **08.08.2007**
(21) Anmeldenummer: 05007246.1
(22) Anmeldetag: 02.04.2005
(51) Int. Cl.: G01R 11/04, G01R 11/24

(54) **Stromzähleranordnung**
Electricity meter assembly
Assemblage avec compteur d'électricité

(30) Priorität: 05.05.2004 DE 102004022128
(43) Veröffentlichungstag der Anmeldung: 09.11.2005
(73) Patentinhaber: ABB PATENT GmbH, 68526 Ladenburg (DE)
(72) Erfinder: Eppe, Klaus-Peter, Dipl.-Ing., 69429 Waldbrunn (DE); Wieland, Ralf, Dipl.-Ing., 69429 Waldbrunn (DE); Popa, Heinz-Erich, Dr.-Ing., 69245 Bammental (DE)
(74) Vertreter: Miller, Toivo

(56) Entgegenhaltungen:
- DE-A1- 10 052 998
- DE-U1- 29 901 587
- DE-U1-7202004 006 07

## Beschreibung

Die Erfindung betrifft eine Stromzählereinrichtung gemäß dem Oberbegriff des Anspruches 1.

In einer elektrischen Installationsanlage, beispielsweise in einer Hausinstallationsanlage befindet sich wenigstens ein Zählerplatz, in dem wenigstens ein Haushaltsstromzähler installiert ist, über den der von dem Energieversorgungsunternehmen gelieferte Strom zu den Verbrauchern geführt wird, so dass die Menge des abgenommenen Stromes erfasst werden kann. Der Haushaltsstromzähler wird dabei auf ein sogenanntes Zählerkreuz am Zählerplatz montiert, was aufwendig ist.

Im Zuge der weiteren Entwicklung soll der Zähler auf einfachste Weise montiert werden können, was gemäß der DE 100 52 998 dadurch erfolgt, dass der Zähler mit seinen an seiner Bodenseite befindlichen Anschlusskontaktstiften ins Innere einer Zählerplattform eingeführt und dann in seine endgültige Stellung, d. h. in seine Betriebsstellung, durch Verschieben überführt wird. Dieser Verschiebevorgang erfolgt parallel zu einer Trägerplatte an der Zählerplattform.

Der in der DE 100 52 998 beschriebene Zähler ist ein elektronischer Haushaltszähler, auf den die Zählerplattform angepasst ist. Bei einer Neuinstallation wird der Zählerplatz fabrikseitig auf den Zähler angepasst; bei Nachrüstungen wird in zweckmäßiger Weise am Zählerplatz ein Adapter angebracht, der dann als Zählerplattform dient, auf die der Zähler aufgesetzt wird.

In der DE 10 2004 001 453 ist eine Stromzählereinrichtung beschrieben, bei der unterhalb der Zählerplattform Kontaktstücke vorgesehen sind, die als U-förmige Kontakttulpen ausgebildet sind. Diese Kontakttulpen sind so innerhalb der Plattform eingebaut, dass die Schenkel zweier zu einer Phase gehöriger Kontakttulpen miteinander fluchten. Zwischen den Kontaktstücken ist eine Brücke hin- und herverschiebbar geführt, wodurch einerseits eine Überbrückung der Kontaktstücke und andererseits eine Unterbrechung des Stromflusses zwischen den Kontaktstücken erreicht werden.

Wenn ein Zähleraustausch erfolgen soll, dann soll während der Austauschzeit eine Stromunterbrechung zum Verbraucher vermieden werden. Aus diesem Grunde sind die Brücken vorgesehen, die so bewegt werden, dass bei der Demontage, bevor die Anschlussfahnen am Zähler von den zugehörigen Kontaktstücken freikommen, die Brücken die beiden zusammengehörenden Kontaktstücke jeder Phase überbrücken, wodurch der Strom sowohl über den Zähler als auch über die Brücken fließt und eine zeitweise Überlappung des Stromflusses bewirkt wird. Sobald der Zähler demontiert ist, fließt der Strom nur über die Brücken, weswegen der Strom nicht mehr gezählt wird. Bei der Montage wird der Zähler auf die Zählerplattform aufgesetzt; die Kontaktfahnen am Zähler greifen in die Brücken ein, verschieben diese, wobei die Brücken solange noch die Kontaktstücke miteinander verbinden, bis die Kontaktfahnen am Zähler in die zugehörigen Kontaktstücke eingreifen; auch hierbei fließt der Strom zeitweise über die Brücken und den Zähler, bis der Zähler in seine endgültige Betriebsstellung verschoben ist und sich die Brücken in Trennstellung befinden.

Das Problem des Schutzes gemäß IP 3X ist bis jetzt noch nicht angesprochen worden.

Aufgabe der Erfindung ist es, eine Zählerplattform der eingangs genannten Art zu schaffen, die den Vorschriften gemäß IP 3 X genügt sowie eine Fehlmontage unmöglich wird.

Diese Aufgabe wird erfindungsgemäß durch die Merkmale des Anspruchs 1 gelöst.

Erfindungsgemäß also ist zwischen der Trägerplatte und den Kontaktstücken eine durch die Kontaktfahnen des Haushaltszählers verschiebbare Platte mit ersten Schlitzen angebracht, wobei die ersten Schlitze bei aufgesetztem Zähler mit zweiten Schlitzen in der Trägerplatte korrespondieren, an deren den Kontaktstücken zugewandten Seite Zapfen angeformt sind, die in Aussparungen der Brücken eingreifen, so dass die Brücken durch die verschiebbare Platte verschoben werden können, und dass an der verschiebbaren Platte ein erstes Verriegelungsmittel und an der Trägerplatte ein damit zusammenwirkendes zweites Verriegelungsmittel vorgesehen ist, wobei das erste Verriegelungsmittel ein Betätigungselement aufweist, welches beim Aufsetzen des Haushaltszählers von diesem betätigt und damit die Verriegelungsstelle zwischen dem ersten und dem zweiten Verriegelungsmittel entriegelbar ist, so dass die Platte vom Haushaltszähler beim Einsetzen beziehungsweise demontieren in Richtung Betriebsstellung und aus dieser heraus verschoben werden kann.

In dem Zustand, in dem der Zähler demontiert ist, ist die Platte durch die Verriegelungsmittel verriegelt, und erst durch Einsetzen des Haushaltszählers werden die Verriegelungsmittel entriegelt, wonach die Platte vom Haushaltszähler verschoben werden kann. Die Platte hat den Vorteil, dass mit ihr die Schutzart IP 3X erreichbar ist und bewirkt in Verbindung mit der Verriegelung, dass eine Fehlermontage verhindert ist, weil der Stromzähler eine Entriegelung erst dann ermöglicht, wenn er sich korrekt in der Stellung befindet, in der seine Grundfläche parallel zur Trägerplatte ausgerichtet ist oder je nach Ausgestaltung auf ihr aufliegt.

Eine vorteilhafte Ausgestaltung der Erfindung kann dahingehend, dass an der der Trägerplatte zugewandten Seite der Platte ein Fortsatz angeformt ist, der mit einem federnd an der Tragplatte angeformten Riegel zusammenwirkt, wobei der Riegel vom Haushaltszähler derart betätigbar ist, dass der Riegel beim Einsetzen des Haushaltszählers auf die Plattform vom Fortsatz freikommt.

Damit der Riegel federnd an der Plattform angebracht ist, befindet sich an der Trägerplatte ein federnder Arm, an dessen freiem Ende der Riegel und zum Zähler hin gewandt ein Zapfen angeformt sind, gegen den die Bodenfläche des Haushaltszählers bei der Montage drückt und dadurch den Arm verformt.

Gemäß einer weiteren vorteilhaften Ausgestaltung der Erfindung kann die Platte selbst einen verformbaren Arm aufweisen, der dann, wenn der Zähler demontiert ist, formschlüssig mit der Trägerplatte verbunden ist, welche formschlüssige Verbindung bzw. Kupplung durch Aufsetzen des Zählers und durch Verformen des Armes verhindert ist.

Wenn der federnde Arm dauernd verformt bleibt, dann ist eine Feder erforderlich, die den Arm wieder in die ursprüngliche Lage zurückdrückt, weil sich der Kunststoff eventuell bleibend plastisch verformt hat.

Weitere vorteilhafte Ausgestaltungen und Verbesserungen der Erfindung sind den abhängigen Ansprüchen zu entnehmen.

Anhand der Zeichnung, in der zwei Ausführungsbeispiele der Erfindung dargestellt sind, sollen die Erfindung sowie weitere vorteilhafte Ausgestaltungen und Verbesserungen der Erfindung und weitere Vorteile näher erläutert und beschrieben werden.

Es zeigen:
- Fig. 1: eine perspektivische Schnittansicht einer erfindungsgemäßen Anordnung
- Fig. 2: eine schematische Schnittansicht eines Haushaltszählers,
- Fig. 3: eine Seitenansicht von Trägerplatte und Platte und
- Fig. 4: eine Seitenansicht einer weiteren Ausführungsform der Verriegelung.

Aus der DE 10 2004 028 223 ist ein Adapter bekannt, der eine Trägerplatte mit Schlitzen aufweist, hinter der Anschlusskontaktstücke angeordnet sind, die mit Anschlussfahnen eines Stromzählers hier eines elektronischen Stromzählers in Verbindung bringbar sind.

Der dort beschriebene Adapter liegt der Erfindung zugrunde. Dieser Adapter ist noch nicht gemäß Schutzvorschrift IP 3X ausgebildet. Um den Adapter gemäß IP 3X auszugestalten, sind die im folgenden beschriebenen Maßnahmen zu treffen.

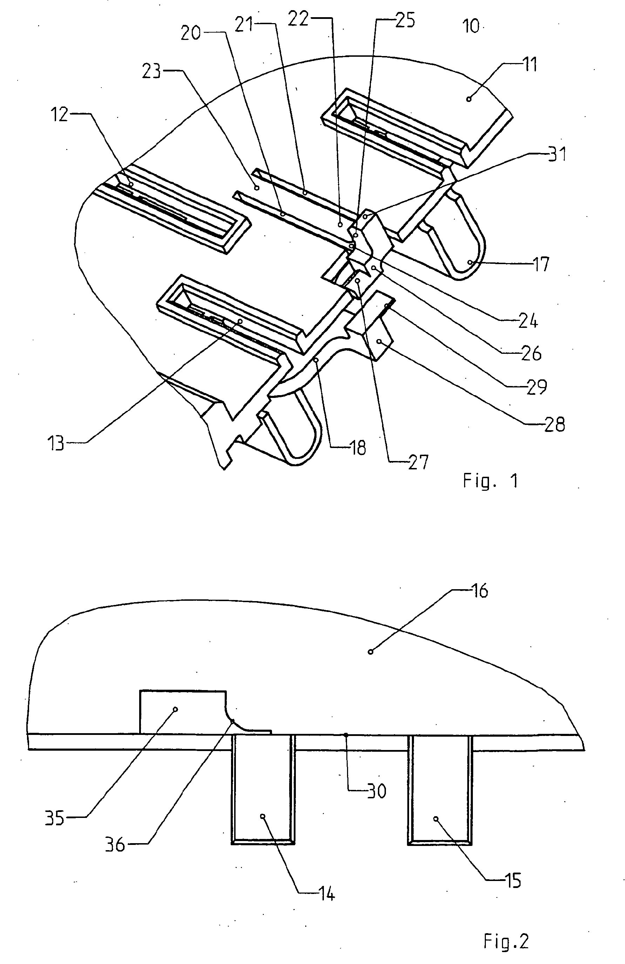

Die Fig. 1 zeigt eine Teilschnittansicht in perspektivischer Darstellung eines Adapters 10, wie er in der genannten Patentanmeldung dargestellt ist. Dieser Adapter 10 besitzt eine Trägerplatte 11, die Schlitze 12, 13 aufweist, durch die Anschlussfahnen 14, 15 an einem elektronischen Haushaltszähler 16 hindurchgreifen, um mit im Inneren des Adapters 10 befindlichen Kontaktstücken 17 in Kontakt zu gelangen. Wie die Anschlusskontakte 17 im Inneren des Adapters 10 ausgebildet und einander zugeordnet sind, ist aus der oben genannten Patentanmeldung näher zu ersehen.

Unterhalb der Trägerplatte 11 befindet sich eine Platte 18, die den Schlitzen 12, 13 entsprechende Schlitze 19 aufweist.

An der Trägerplatte 11 sind zwei parallel zueinander verlaufende weitere Schlitze 20, 21 angeformt, die in der Trägerplatte 11 einen Finger oder Arm 22 bilden, der elastisch verformbar ist. Er ist an der Trägerplatte 11 an seinem einen Ende 23 eingespannt, wogegen das andere Ende 24 federnd beweglich ist. Am freien Ende des Fingers 22 ist ein Zapfen 25 angeformt, der die äußere, dem nicht gezeigten Stromzähler zugewandte Oberfläche der Trägerplatte 11 überragt; in entgegengesetzte Richtung, d. h. ins Innere des durch die Trägerplatte 11 abgeschlossenen Gehäuses springt von dem Finger 22 ein Riegel 26 vor, der eine L-Form aufweist, deren freier Schenkel 27 parallel zur Innenfläche der Trägerplatte 11 und senkrecht zur Längserstreckung des Fingers 22 verläuft.

An der zur Trägerplatte 11 zugewandten Fläche der Platte 18 ist ein ebenfalls L-förmiger Fortsatz 28 angeformt, dessen freier L-förmiger Schenkel 29 parallel zur Ebene der Platte 18 verläuft und in dem Zustand, in dem der Haushaltszähler 16 nicht auf die Trägerplatte 11 aufgesetzt ist, mit dem freien Schenkel 27 des Riegels 26 in einer Ebene liegt, die im Ruhezustand im gleichen Abstand von der Trägerplatte 11 gelegen ist; der freie Schenkel 27 liegt im Bewegungsweg des Schenkels 29 des Fortsatzes 28, im Ruhezustand. Damit ist die Verschiebbarkeit der Platte 18 innerhalb des Adapters 10 verhindert, weil der freie Schenkel 29 gegen den Schenkel 27 seitlich zum Anschlag kommt. Die Schenkel springen in entgegen gesetzte Richtung vor und liegen bezogen auf die Schieberichtung nebeneinander.

Wenn nun der elektronische Haushaltszähler 16 aufgesetzt wird, dann drückt die Bodenfläche 30 des Haushaltszählers gegen die freie Stirnfläche 31 des Zapfens 25, wodurch der Finger 22 oder Arm 22 verformt wird, so dass der Schenkel 27 unterhalb des Schenkels 29 zu liegen kommt, wodurch der Schenkel 29 frei von dem Schenkel 27 wird. Damit kann die Platte 18 von den Kontaktmessern 14, 15 in Richtung Betriebsstellung des Haushaltszählers mitgenommen werden.

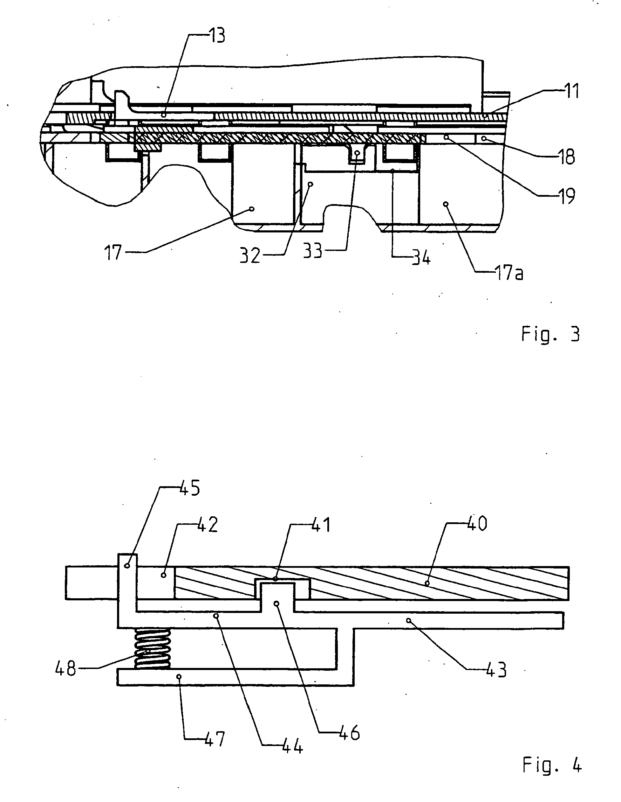

Die Fig. 3 zeigt zwei Kontaktstücke 17, 17a, die von einer Brücke 32 überbrückt sind, wenn der elektronische Haushaltszähler 16 nicht montiert ist. Damit die Brücke 32 verschoben werden kann, besitzt die Platte 18 eine der Anzahl der Brücken entsprechende Anzahl von Vorsprüngen 33, die in eine Aussparung 34 an der Brücke 32 eingreifen und somit alle Brücken beim Einsetzen des Haushaltszählers gleichzeitig betätigen.

Wie die Kontaktstücke 17, 17a und die Brücken 32 ausgebildet sind, ist z.B. auch der DE 10 2004 028 223 zu entnehmen.

An welcher Stelle die Verriegelung, d.h. der Arm mit dem Riegel und der Fortsatz am Adapter angebracht sind, nicht von sehr großer Bedeutung. Wichtig ist, dass die Stelle des Riegels und des Fortsatzes an bezogen auf den Zähler passender Stelle angeordnet sind, wie im folgenden ausgeführt.

Es ist nämlich folgendes dabei zu berücksichtigen: wenn die Verriegelungsstelle sich irgendwo zwischen dem Beginn der Bewegung des Zählers und dem Ende dieser Bewegung befindet, dann würde sich der Zapfen 25 dauernd im Bereich des Bodens des Zählers befinden und wäre einer dauernden Biegebelastung unterworfen. Dadurch würde der Arm auf Dauer in seiner gebogenen Stellung gehalten. Da sich der Kunststoff mit der Zeit plastisch verformt, bliebe der Arm auch nach Entfernen des Zählers in der verformten Stellung. Daher besitzt der Haushaltszähler 16 an seiner Unterseite an passender Stelle eine Vertiefung 35, in die der Zapfen 25 in der Betriebsstellung des Zählers eingreift, so dass eine dauernde Biegebelastung des Armes 22 vermieden ist. Die Vertiefung 35 besitzt eine dem Zapfen 25 benachbarte Schmalwand 36, die abgeschrägt ist, so dass der Zapfen 25 bei der Demontage auf die Schrägfläche 36 aufgleiten kann, so dass der Arm 22 wieder in Ausgangsstellung gelangt und die Platte 18 von dem Haushaltszähler in die in Fig. 1 dargestellte Stellung verfahren werden kann.

Die Verriegelung der Platte 18 gegenüber der Trägerplatte 11 mittels der beiden Schenkel 27, 29 hat den Zweck, dass die Platte 18 nicht verschoben werden kann, wenn eine Fehlmontage des Zählers erfolgt, d.h. wenn der Zähler schräg aufgesetzt wird. In diesem Falle nämlich würden die Kontaktmesser 14 oder 15 in die entsprechenden Schlitze der Platte 18 eingreifen können, wodurch eine Verschiebung der Platte 18 möglich wäre. Darüber hinaus könnten Kontaktfahnen am Zähler bei nicht korrekter Montage an Potential (Spannung) gelegt werden, was eine Gefährtdung des Montagepersonals mit sich brächte.

Erst wenn die Verriegelung vom Stromzähler bei dessem korrektem Einsetzen entriegelt ist, kann der Stromzähler mit der Platte verschoben werden.

Um zu vermeiden, dass der Zähler verändert werden muss, d.h. dass in die Bodenseite des Zählers die Vertiefung 35 eingebracht werden muss, kann die Verriegelungsstelle auch in einem Bereich angeordnet sein, in dem sich der Zähler bei Beginn der Montage befindet; wenn der Zähler dann in seine endgültige Betriebsstellung geht, wird die Verriegelung wieder freigegeben, d. h. der Zapfen befindet sich außerhalb der Betriebsstellung des Zählers. In dem Fall, wenn der Zähler demontiert werden muss, wird der Zähler beim Zurückfahren aus der Betriebsstellung in die Entnahmestellung auf den Zapfen auftreffen und diesen herunterdrücken, so dass der Zähler in seine Demontagelage verschoben werden kann.

Aufgrund der Anordnung der Kontaktstücke innerhalb des Adapters kann eine Fehlmontage nicht zum Verlust des Schutzes IP 3X führen. Wenn der Zähler in Bewegungsrichtung hinten zuerst aufgesetzt wird, drückt er in diesem Falle zwar den Zapfen nach unten; eine weiter Bewegung des Zählers allerdings in Richtung auf die Kontaktstücke endet aber, bevor die Kontaktfahnen die Kontaktstücke erreicht haben. Insofern ist auch hier eine Verschiebung nur dann möglich, wenn der Zähler korrekt aufgesetzt ist.

Dass der Zapfen dann eine entsprechende Endfläche aufweisen muss, also in entsprechender Weise abgeschrägt sein muss, ist selbstverständlich. Beispielsweise könnte der Zapfen eine Dachform aufweisen, wobei die Dachschrägen in geeigneter Weise zu bemessen sind.

Die Fig. 4 zeigt eine Teilschnittansicht durch eine Trägerplatte mit Platte nach einer weiteren Ausgestaltung der Erfindung.

Die Trägerplatte 40 besitzt an ihrer den Kontaktstücken zugewandten Seitenfläche eine Vertiefung 41 und einen Schlitz 42. Zwischen der Trägerplatte 40 und den nicht gezeigten Kontaktstücken befindet sich eine Platte 43, die der Platte 18 entspricht. Die Platte 43, die den Kontaktstücken zugeordnet ist und die, wie oben dargestellt, vom Zähler verschoben wird, so dass auch die Brücken zwischen den Kontaktstücken verschoben werden, besitzt einen federnden Arm 44, der in gleicher Weise hergestellt sein kann wie der Arm 22. Am freien Ende des Armes 44 ist ein dem Zapfen 25 entsprechender Zapfen 45 vorgesehen, der die Trägerplatte im Bereich des Schlitzes 42 durchgreift und die Trägerplatte 40 überragt, hin zum Zähler. An dem Arm ist weiterhin ein Vorsprung 46 angeformt, der im Zustand, wenn der Zähler demontiert ist, in die Vertiefung 41 hineingreift.

Wenn der Zähler aufgesetzt wird, wird der Zapfen 45 vom Zähler betätigt und der Vorsprung 46 gelangt außer Eingriff mit der Vertiefung 41. Dadurch kann die Platte 43 verschoben werden, wobei der Schlitz 42 die Verschiebung der Platte 43 nicht behindert.

Da bei dieser Lösung der Kunststoff des Armes 44 dauerhaft belastet wird, kann sich dieser verformen, so dass sich bei einer Rückführung des Zählers weder der Zapfen 45 noch der Vorsprung 46 in ihre ursprüngliche Form zurückbewegen. Zu diesem Zwecke ist an der Platte 43 ein Federträger 47 angeformt, der als Gegenlager für eine Feder 48 dient, die zwischen dem Arm 44 und dem Federträger 47 angeordnet ist und den Arm 44 dauernd in Richtung Eindrücken des Vorsprunges 46 in die Vertiefung 41 beaufschlagt.

Nachzutragen ist, dass dann, wenn von "Zählerplattform" die Rede ist, eine Anordnung gemeint ist, auf die der besagte elektronische Haushaltszähler aufgesetzt ist. Das kann ein fabrikseitig gefertigter Zählerplatz oder ein Adapter sein, der bei einer Nachrüstung mit dem elektrischen Zähler auf einem Zählerkreuz befestigt werden kann.

## Patentansprüche

1. Zählerplattform zum Aufsetzen eines Haushaltszählers (16), insbesondere eines elektronischen Haushaltszählers (16), mit einer Trägerplatte (11), auf die der Haushaltszähler (16) aufsetzbart ist, wobei durch erste Schlitze (12,13) in der Trägerplatte (11) hindurch Kontaktfahnen (14,15) des Haushaltszählers (16) zu Kontaktstücken (17, 17a) sowie Haltekrallen in die Zählerplattform einführbar sind, und wobei bei der Montage in die Betriebsstellung und aus dieser heraus die zu jeder Phase gehörenden Kontaktstücke (17, 17a) mittels einer verschiebbaren Brücke (32) verbunden und voneinander getrennt werden, **dadurch gekennzeichnet, dass** zwischen der Trägerplatte (11, 40) und den Kontaktstücken (17,17a) eine durch die Kontaktfahnen (14,15) des Haushaltszählers (16) verschiebbare Platte (18, 43) mit zweiten Schlitzen (19) angebracht ist, wobei die zweiten Schlitze (19) bei aufgesetztem Zähler mit den ersten Schlitzen (12,13) in der Trägerplatte korrespondieren, an deren den Kontaktstücken (17,17a) zugewandten Seite Zapfen (25) angeformt sind, die in Aussparungen (34) der Brücken (32) eingreifen, so dass die Brücken (32) durch die verschiebbare Platte (18) verschoben werden können, und dass an der verschiebbaren Platte (18) ein erstes Verriegelungsmittel (28,29; 44,46) und an der Trägerplatte (11) ein damit zusammenwirkendes zweites Verriegelungsmittel (22, 27; 41) vorgesehen ist, wobei das erste Verriegelungsmittel (28,29; 44,46) ein Betätigungselement (25; 45) aufweist, welches beim Aufsetzen des Haushaltszählers (16) von diesem betätigt und damit die Verriegelungsstelle zwischen dem ersten und dem zweiten Verriegelungsmittel entriegelbar ist, so dass die Platte (18) vom Haushaltszähler (16) beim Einsetzen beziehungsweise Demontieren in Richtung Betriebsstellung und aus dieser heraus verschoben werden kann.

2. Zählerplattform nach Anspruch 1, **dadurch gekennzeichnet, dass** an der der Trägerplatte (11) zugewandten Seite der Platte (18) ein Fortsatz (28) angeformt ist, der mit einem federnd an der Tragplatte angeformten Riegel (26) zusammenwirkt, wobei der Riegel (26) vom Haushaltszähler (16) derart betätigbar ist, dass der Riegel (26) beim Einsetzen des Haushaltszählers (16) auf die Plattform vom Fortsatz (28) freikommt.

3. Zählerplattform nach Anspruch 2, **dadurch gekennzeichnet, dass** an der Trägerplatte (11) ein federnder Arm gebildet ist, an dessen freiem Ende (23, 24) der Riegel (26) und zum Zähler hingewandt ein Zapfen (25) angeformt sind, gegen den die Bodenfläche des Haushaltszählers (16) bei der Montage drückt und **dadurch** den Arm verformt.

4. Zählerplattform nach Anspruch 3; **dadurch gekennzeichnet, dass** der federnde Arm durch Schlitze (20, 21) in der Trägerplatte (11) gebildet ist.

5. Zählerplattform nach einem der Ansprüche 2 bis 4, **dadurch gekennzeichnet, dass** der Riegel (26) und der Fortsatz (28) je eine L-Form besitzen, deren freie Schenkel (27, 29) in dem Zustand, wenn der Haushaltszähler (16) nicht montiert ist, in einer parallel zur Trägerplatte (11) verlaufende Ebene, nebeneinander liegen, so dass ein Verschieben der Platte (18) ohne Einsetzen des Haushaltszählers (16) blockiert ist, und in dem Zustand, in dem der Haushaltszähler (16) aufgesetzt ist, sich in unterschiedlichen Ebenen befinden.

6. Zählerplattform nach Anspruch 5, **dadurch gekennzeichnet, dass** die Schenkel (27, 29) der L-Form des Riegels (26) und des Fortsatzes (28) in entgegengesetzte Richtung vorspringen, wobei sich in der Blockierstellung die Schenkel (27, 29) nebeneinander in einer Ebene und in der Entriegelstellung in unterschiedlichen Ebenen übereinander befinden.

7. Zählerplattform nach einem der Ansprüche 2-6 **dadurch gekennzeichnet, dass** der Riegel (26) und der Fortsatz (28) an einer Stelle außerhalb des Bereiches angeordnet sind, in dem sich der Zähler (16) in seiner Betriebsstellung befindet

8. Zählerplattform nach einem der Ansprüche 2 bis 6, **dadurch gekennzeichnet, dass** der Riegel (26) und der Fortsatz (28) in einem Bereich angeordnet sind, der vom Zähler (16) in seiner Betriebsstellung überdeckt ist, und dass an der Bodenfläche des Haushaltszählers (16) eine Vertiefung (35) vorgesehen ist, in die der Zapfen (25) im montierten Endzustand einrastet.

9. Zählerplattform nach Anspruch 8, **dadurch gekennzeichnet, dass** die Vertiefung (35) länglich rechteckig ist und die an der beim Aufsetzen den Haushaltszähler (16) dem Zapfen (25) benachbarten Seite befindliche Schmalseitenwand der Vertiefung (35) abgeschrägt ist, wobei der Zapfen (25) beim Montieren und Demontieren auf der schrägen Schmalwand (36) gleiten kann.

10. Zählerplattform nach Anspruch 1, **dadurch gekennzeichnet, dass** an der Platte (43) ein federnder Arm (44) gebildet ist, an dessen der Trägerplatte (40) zugewandten Seite ein Vorsprung (46) und ein Riegel (45) angeformt ist, und dass die Trägerplatte eine Vertiefung (41) auf ihrer der Platte (43) zugewandten Seite aufweist, *wobei der Vorsprung im Zustand, wenn der Zähler demontiert ist, in die Vertiefung (41) hineingreift,* und wobei der Riegel (45) die Trägerplatte bei demontiertem Zähler überragt und beim Verschieben des Zählers innerhalb eines an der Platte (40) angebrachten Schlitzes (42) verschiebbar ist.

11. Zählerplattform nach Anspruch 10, **dadurch gekennzeichnet, dass** der Arm (44) mittels einer Feder (48) dauernd in Richtung der Stellung beaufschlagt ist, in der sich der Arm (44) bei demontiertem Zähler befindet.

## Claims

1. A meter platform for placing a domestic supply meter (16), especially an electronic domestic supply meter (16), comprising a carrier plate (11) on which the domestic supply meter (16) can be placed, with contact lugs (14, 15) of the domestic supply meter (16) being guidable to contact elements (17, 17a) and holding claws in the meter platform through first slits (12, 13) in the carrier plate (11), and with the contact elements (17, 17a) belonging to each phase being connected by means of a displaceable bridge (32) and being separated from each other during the mounting into the operating position and from the same, **characterized in that** a plate (18, 43) with second slits (19) is attached between the carrier plate (11, 40) and the contact elements (17, 17a), which plate is displaceable by the contact lugs (14, 15) of the domestic supply meter (16), with the second slits (19) corresponds with the first slits (12, 13) in the carrier plate when the meter is mounted, with pins (25) being formed on the side of said first slits facing the contact elements (17, 17a, which pins engage in recesses (34) of the bridges (32), so that the bridges (32) can be displaced by the displaceable plate (18), and that a first locking means (28, 29; 44, 46) is provided on the displaceable plate (18) and a second locking means (22, 27; 41) cooperating with the same is provided on the carrier plate (11), with the first locking means (28, 29; 44, 46) comprising an actuating means (25; 45) which upon placement of the domestic supply meter (16) is actuated by the same and the locking point between the first and the second locking means can be unlocked, so that the plate (18) can be displaced into the operating position and out of the same during the insertion or disassembly.

2. A meter platform according to claim 1, **characterized in that** a projection (28) is formed on the side of the plate (18) facing the carrier plate (11), which projection cooperates with a locking bar (26) which is formed resiliently on the carrier plate, with the locking bar (26) being actuated by the domestic supply meter (16) in such a way that the locking bar (26) is released from the projection (28) during the insertion of the domestic supply meter (16) on the platform.

3. A meter platform according to claim 2, **characterized in that** a resilient arm is formed on the carrier plate (11), on whose free end (23, 24) the locking bar (26) and a pin (25) facing the meter are formed, against which the floor surface of the domestic supply meter (16) presses during the mounting and thus deforms the arm.

4. A meter platform according to claim 3, **characterized in that** the resilient arm is formed by slits (20, 21) in the carrier plate (11).

5. A meter platform according to one of the claims 2 to 4, **characterized in that** the locking bar (26) and the projection (28) each have the shape of an L whose free legs (27, 29) are situated adjacent to one another in a plane extending parallel to the carrier plate (11) in the state when the domestic supply meter (16) is not mounted, so that a displacement of the plate (18) is blocked without any insertion of the domestic supply meter (16) and they are situated in different planes in the state in which the domestic supply meter is placed.

6. A meter platform according to claim 5, **characterized in that** the legs (27, 29) of the L-shape of the locking bar (26) and the projection (28) protrude in opposite directions, with the legs (27, 29) being situated adjacent to one another in the blocking position and in different planes above another in the unlocking position.

7. A meter platform according to one of the claims 2 to 6, **characterized in that** the locking bar (26) and the projection (28) are arranged at a point outside of the region in which the meter (16) is situated in its operating position.

8. A meter platform according to one of the claims 2 to 6, **characterized in that** the locking bar (26) and the projection (28) are arranged in a region which is covered by the meter (16) in its operating position, and that a recess (35) is provided on the floor surface of the domestic supply meter (16) into which the pin (25) latches in the mounted end state.

9. A meter platform according to claim 8, **characterized in that** the recess (35) is rectangular oblong and the narrow side wall of the recess (35) which is adjacent to the pin (25) when the domestic supply meter (16) is inserted is beveled, with the pin (25) being able to slide on the oblique narrow wall (36) during the mounting and dismounting.

10. A meter platform according to claim 1, **characterized in that** a resilient arm (44) is formed on the plate (43), with a projection (46) and a locking bar (45) being formed on its side facing the carrier plate (40), and that the carrier plate comprises a depression (41) on its side facing the plate (43), with the projection engaging into the depression (41) in the state when the meter is dismounted, and with the locking bar (45) protruding beyond the carrier plate when the meter is dismounted and is displaceable during the displacement of the meter within a slit (42) applied to the plate (40).

11. A meter platform according to claim 10, **characterized in that** the arm (44) is permanently pressurized by means of a spring (48) in the direction of the position in which the arm (44) is situated when the meter is dismounted.

## Revendications

1. Plate-forme pour compteur pour la pose d'un compteur domestique (16), en particulier d'un compteur domestique électronique (16), avec une plaque de support (11) sur laquelle le compteur domestique (16) peut être posé, des lames de contact (14, 15) du compteur domestique (16) ainsi que des griffes de maintien pouvant être insérées dans la plate-forme pour compteur à travers des premières fentes (12, 13) dans la plaque de support (11) vers des éléments de contact (17, 17a), et les éléments de contact (17, 17a) associés à chaque phase étant reliés lors du montage dans la position de service et hors de celle-ci et séparés les uns des autres au moyen d'un pont (32) coulissant, **caractérisée en ce qu'**il est prévu entre la plaque de support (11, 40) et les éléments de contact (17, 17a) une plaque (18, 43) avec des deuxièmes fentes (19) pouvant être déplacée par les lames de contact (14,15) du compteur domestique (16), les deuxièmes fentes (19) correspondant, lorsque le compteur est posé, aux premières fentes (12, 13) dans la plaque de support, sur laquelle sont formés sur le côté orienté vers les éléments de contact (17, 17a) des goujons (25) qui se mettent en prise dans des ouvertures (34) des ponts (32), de sorte que les ponts (32) peuvent être déplacés par la plaque coulissante (18), et **en ce qu'**il est prévu sur la plaque coulissante (18) un premier moyen de verrouillage (28, 29 ; 44, 46) et sur la plaque de support (11) un deuxième moyen de verrouillage (22, 27 ; 41) coopérant avec celui-ci, le premier moyen de verrouillage (28, 29 ; 44, 46) comprenant un élément d'actionnement (25 ; 45) qui est actionné par le compteur domestique (16) lors de la pose de celui-ci et permet ainsi le déverrouillage du point de verrouillage entre le premier moyen de verrouillage et le deuxième, de sorte que la plaque (18) peut être déplacée dans la position de service et retirée de celle-ci par le compteur domestique (16) lors de l'insertion et du démontage.

2. Plate-forme pour compteur selon la revendication 1, **caractérisé en ce qu'**il est prévu formée sur le côté de la plaque (18) orienté vers la plaque de support (11) une saillie (28) qui coopère avec un loquet (26) formé de façon élastique sur la plaque de support, lequel loquet (26) peut être actionné par le compteur domestique (16) de telle façon que le loquet (26) se dégage de la saillie (28) lorsque le compteur domestique (16) est inséré sur la plate-forme.

3. Plate-forme pour compteur selon la revendication 2, **caractérisée en ce qu'**il est prévu sur la plaque de support (11) un bras élastique dont l'extrémité libre (23, 24) porte le loquet (26) et, en direction du compteur, un goujon (25) contre lequel la surface de fond du compteur domestique (16) s'appuie lors du montage en déformant ainsi le bras.

4. Plate-forme pour compteur selon la revendication 3, **caractérisée en ce que** le bras élastique est formé par des fentes (20, 21) dans la plaque de support (11).

5. Plate-forme pour compteur selon l'une des revendications 2 à 4, **caractérisé en ce que** le loquet (26) et la saillie (28) ont tous deux la forme d'un L dont les bras libres (27, 29) se trouvent, lorsque le compteur domestique (16) n'est pas monté, l'un à côté de l'autre dans un plan parallèle à la plaque de support (11), de sorte qu'une translation de la plaque (18) sans insertion du compteur domestique (16) est bloquée, et se trouvent dans des plans différents lorsque le compteur domestique (16) est posé.

6. Plate-forme pour compteur selon la revendication 5, **caractérisé en ce que** les bras (27, 29) de la forme de L du loquet (26) et de la saillie (28) dépassent dans des directions opposées, les bras (27, 29) se trouvant l'un à côté de l'autre dans un plan dans la position de blocage et dans des plans différents dans la position de déverrouillage.

7. Plate-forme pour compteur selon l'une des revendications 2 à 6, **caractérisée en ce que** le loquet (26) et la saillie (28) sont disposés à un endroit situé en dehors de la zone dans laquelle se trouve le compteur (16) dans sa position de service.

8. Plate-forme pour compteur selon l'une des revendications 2 à 6, **caractérisée en ce que** le loquet (26) et la saillie (28) sont disposés dans une zone qui est couverte par le compteur (16) dans sa position de service, et **en ce qu'**il est prévu sur la surface de fond du compteur domestique (16) un renfoncement (35) dans lequel le goujon (25) s'engage dans l'état de montage final.

9. Plate-forme pour compteur selon la revendication 8, **caractérisée en ce que** le renfoncement (35) est en forme de rectangle allongé et le côté étroit du renfoncement qui se trouve du côté voisin du goujon (25) lors de la pose du compteur domestique (16) est biseauté, le goujon (25) pouvant coulisser sur la paroi étroite (36) oblique lors du montage et du démontage.

10. Plate-forme pour compteur selon la revendication 1, **caractérisée en ce qu'**un bras élastique (44) est formé sur la plaque (43) et porte sur son côté orienté vers la plaque de support (40) une saillie (46) et un loquet (45), et **en ce que** la plaque de support possède un renfoncement (41) sur sa face orientée vers la plaque (43), la saillie se mettant en prise dans le renfoncement (41) lorsque le compteur est démonté et le loquet (45) dépassant de la plaque de support lorsque le compteur est démonté et pouvant se déplacer à l'intérieur d'une fente (42) ménagée sur la plaque (40) lors de la translation du compteur.

11. Plate-forme pour compteur selon la revendication 10, **caractérisée en ce que** le bras (44) est contraint en permanence au moyen d'un ressort (48) en direction de la position dans laquelle le bras (44) se trouve lorsque le compteur est démonté.
